# EUROPEAN PATENT APPLICATION

(11) **EP 4 481 804 A1**
(43) Date of publication of application: **25.12.2024**
(21) Application number: 24178292.9
(22) Date of filing: 27.05.2024
(51) Int. Cl.: H01L 23/00, B22F 1/107, B22F 5/00

(54) **SINTER BONDING SHEET**

(30) Priority: 08.06.2023 JP 2023094868
(71) Applicant: NITTO DENKO CORPORATION, Ibaraki-shi Osaka 567-8680 (JP)
(72) Inventor: MITA, Ryota, Osaka, 567-8680 (JP); OKOBA, Yuichi, Osaka, 567-8680 (JP)
(74) Representative: Grünecker Patent- und Rechtsanwälte PartG mbB

(57) **Abstract**

Provided is a sinter bonding sheet including a sinter bonding layer that includes: sinterable particles containing a conductive metal; and an organic binder, in which a maximum size among sizes of cavities observed in an observation image of a surface of the sinter bonding layer at a magnification of 100 times is 100 µm or less.

## Description

### FIELD OF THE INVENTION

The present invention relates to a sinter bonding sheet used for producing, for example, a semiconductor device.

### BACKGROUND OF THE INVENTION

Conventionally known is a sinter bonding sheet used for producing a semiconductor device. The sinter bonding sheet of this type includes a sinter bonding layer including: sinterable particles containing a conductive metal; and an organic binder. The sinter bonding layer including the organic binder has pressure-sensitive adhesiveness. In producing the semiconductor device, the sinter bonding layer is placed between one surface of a board and a semiconductor element (e.g., semiconductor chip) and subjected to sintering treatment to thereby allow the board and the semiconductor element to be bonded to each other via the sinter bonding layer. For example, steps as shown below are carried out to produce the semiconductor device.
(1) A dicing tape formed of a substrate and an adhesive layer laminated on each other is prepared, and a semiconductor wafer is attached on the adhesive layer of the dicing tape for fixing, followed by being divided by dicing into a plurality of individual semiconductor elements.
(2) One of the plurality of semiconductor elements is separated from the adhesive layer and lifted up using a jig such as a collet, and the one semiconductor element is then pressed on a sinter bonding layer of a sinter bonding sheet. With such pressing force, a portion of the sinter bonding layer is cut out into an individual piece having such a size as to correspond to the size of the one semiconductor element. The individual piece of the sinter bonding layer is simultaneously caused to adhere to the semiconductor element, and the jig such as the collet is pulled up to thereby pick up the one semiconductor element with the individual piece of the sinter bonding layer adhering thereto.
(3) The one semiconductor element with the individual piece of the sinter bonding layer adhering thereto is caused to adhere to one surface of a board (i.e., a mounting area of a semiconductor element). That is, the one semiconductor element is temporarily fixed to the board.
(4) Steps (2) and (3) are similarly carried out a plurality of times to temporarily fix a plurality of the semiconductor elements with the individual pieces of the sinter bonding layer respectively adhering thereto within the mounting areas of the semiconductor elements. An intermediate product of the semiconductor device is thus obtained.
(5) The intermediate product of the semiconductor device is subjected to sintering treatment in which the intermediate product of the semiconductor device is heated at a temperature at which sinterable particles in the sinter bonding layer can be sintered to each other, to thereby at least partially eliminate the organic binder from the sinter bonding layer while sintering the sinterable particles to each other. Thus, the plurality of semiconductor elements are bonded to the respective mounting areas of the semiconductor elements.

After the above steps are carried out, the sinterable particles included in the sinter bonding layer are sintered to each other to thereby allow the plurality of semiconductor elements to be fixed within the respective mounting areas of the semiconductor elements. That is, the plurality of semiconductor elements are fixed to the respective mounting areas of the semiconductor elements via the respective individual pieces of the sinter bonding layer that have been subjected to sintering treatment.

In substitution for steps (1) and (2) above, it is also possible in producing the semiconductor device that: the sinter bonding layer be layered on the adhesive layer of the dicing tape and the semiconductor wafer be further attached to the sinter bonding layer; and the semiconductor wafer with the sinter bonding layer attached thereto be divided into individual pieces to pick up a semiconductor element with the sinter bonding layer attached thereto.

Known as a sinter bonding sheet that can be used in carrying out the method for producing the semiconductor device as above is, for example, a sheet including a sinter bonding layer that turns a firm sintered layer after sintering treatment (for example, JP 2017-066384 A).

Specifically, the sinter bonding layer of the sinter bonding sheet disclosed in JP 2017-066384 A has air hole portions, an average area in cross section of which falls within a range of 0.005 µm² to 0.5 µm² after the sinter bonding layer is heated under a specific heating condition. The specific heating condition includes heating from 80 °C to 300 °C at a temperature rising rate of 1.5 °C/sec and then maintaining the temperature at 300 °C for 2.5 minutes under a pressure of 10 MPa.

### SUMMARY OF THE INVENTION

### Technical Problem

The individual piece of the sinter bonding layer after sintering treatment may result in insufficient bonding to an adherend such as a board or a semiconductor element if used under an environment in which temperature increases and decreases repetitively. Specifically, the individual piece of the sinter bonding layer subjected to repetitive temperature rises and falls can cause the sinter bonding layer and the adherend to be partially separated from each other at an interface therebetween, or can cause cracks inside the sinter bonding layer. The removal or the cracks may cause failure to sufficiently maintain the bonding between the sinter bonding layer and the adherend, leading to degraded reliability as a product.

However, no sufficient consideration appears to have been made on a sinter bonding sheet capable of sufficiently maintaining bonding to an adherend when used under an environment in which temperature increases and decreases repetitively.

It is therefore an object of the present invention to provide a sinter bonding sheet capable of sufficiently maintaining bonding to an adherend when used in an environment in which temperature increases and decreases repetitively.

### Solution to Problem

In order to achieve the above object, a sinter bonding sheet according to the present invention is a sinter bonding sheet including a sinter bonding layer that includes: sinterable particles containing a conductive metal; and an organic binder, in which a maximum size among sizes of cavities observed in an observation image of a surface of the sinter bonding layer at a magnification of 100 times is 100 µm or less.

### BRIEF DESCRIPTION OF DRAWINGS

Fig. 1 is a schematic cross-sectional view of a sinter bonding sheet of this embodiment obtained by cutting the sinter bonding sheet in its thickness direction.
Fig. 2A is a schematic cross-sectional view showing a state where one semiconductor chip is lifted up from a dicing tape by a collet.
Fig. 2B is a schematic cross-sectional view showing a state where a part of a sinter bonding layer of the sinter bonding sheet is cut out into an individual piece.
Fig. 2C is a schematic cross-sectional view showing a state where a part of the sinter bonding layer of the sinter bonding sheet is cut out into an individual piece.
Fig. 2D is a schematic cross-sectional view showing a state where the one semiconductor chip with the individual piece of the sinter bonding layer attached thereto is temporarily fixed to a board.
Fig. 3A is a schematic cross-sectional view showing a state where another semiconductor chip is lifted up from the dicing tape by the collet.
Fig. 3B is a schematic cross-sectional view showing a state where the other semiconductor chip with the individual piece of the sinter bonding layer attached thereto is temporarily fixed to a board.
Fig. 4A is a schematic cross-sectional view showing an example state where the individual piece of the sinter bonding layer is heated while being pressed.
Fig. 4B is a schematic cross-sectional view showing an example state where the individual piece of the sinter bonding layer is heated without being pressed.
Fig. 5A shows photos showing some examples of observation images of surfaces of sinter bonding layers.
Fig. 5B shows photos showing some examples of observation images of surfaces of sinter bonding layers.
Fig. 5C shows photos showing some examples of observation images of surfaces of sinter bonding layers.

### DETAILED DESCRIPTION OF THE PREFERRED EMBODIMENT

A description will be hereinafter given on one embodiment of a sinter bonding sheet according to the present invention with reference to the drawings.

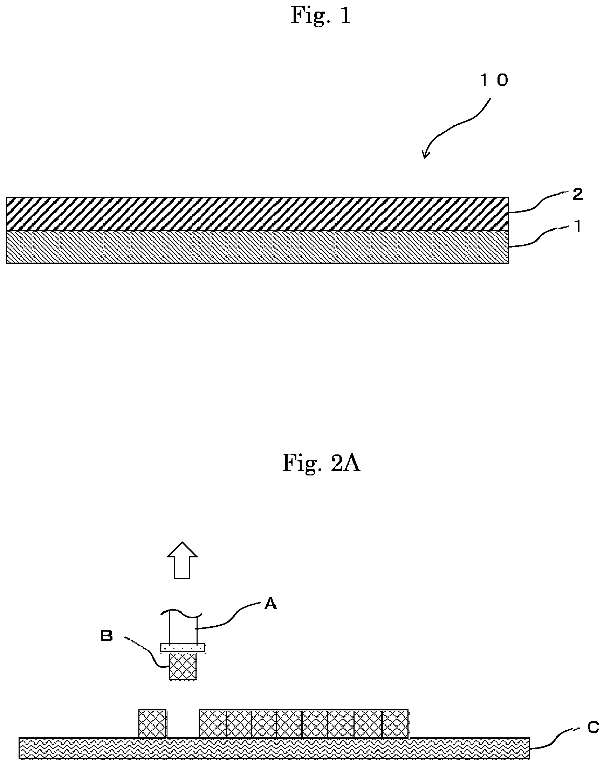

As shown in Fig. 1, a sinter bonding sheet 10 according to this embodiment includes a sinter bonding layer 2 that includes: sinterable particles containing a conductive metal; and an organic binder. The sinter bonding layer 2 is layered on one surface of a support layer 1.

### [Sinter bonding layer of sinter bonding sheet]

The sinter bonding sheet 10 of this embodiment has, for example, an elongated strip shape. The sinter bonding sheet 10 of this embodiment can be stored in a state wound around into a cylindrical shape.

The sinter bonding layer 2 including the organic binder has pressure-sensitive adhesiveness. Thus, the sinter bonding layer 2 subjected to pressing force can temporarily adhere to an adherend. When the sinter bonding layer 2 is subjected to sintering treatment, sinterable particles therein are sintered to each other. The sinter bonding layer 2 after sintering treatment is disposed, for example, between a board and a semiconductor chip B for bonding these to each other. The sinter bonding layer 2 after sintering treatment has the organic binder at least partially eliminated. The organic binder in the sinter bonding layer 2 is preferably substantially absent, more preferably totally absent.

A maximum size among sizes of cavities observed in an observation image of a surface of the sinter bonding layer 2 at a magnification of 100 times is 100 µm or less. The definition "a maximum size of 100 µm or less" encompasses the configuration that only one cavity is observed or no cavity is observed at all. The sinter bonding layer 2 configured as above can sufficiently maintain bonding between the sinter bonding layer 2 and the adherend even when the sinter bonding layer 2 is used in an environment in which temperature increases and decreases repetitively. The maximum size is preferably 95 µm or less, more preferably 70 µm or less, further preferably 50 µm or less. It is most preferable that no cavity be observed at all in the observation image. When the cavities are observed, the largest cavity can have a size of 5 µm or more.

In this embodiment, an area proportion of the cavities is preferably 5.0% or less within the observation image with an area of at least 9 mm². Since the sinter bonding layer 2 has the area proportion of the cavities of 5.0% or less as above, the sinter bonding layer 2 can more sufficiently maintain its bonding to the adherend even when the sinter bonding layer 2 is used in an environment in which temperature increases and decreases repetitively. The area proportion of the cavities is preferably 2.0% or less, more preferably 1.0% or less, further preferably 0.5% or less, most preferably 0%. The area proportion of the cavities can be 0% or more.

The abovementioned maximum size of the largest cavity can be made smaller by further lowering a solid content concentration of a varnish (to be discussed in details later) including the sinterable particles, the organic binder, and an organic solvent when the sinter bonding layer 2 is fabricated. The maximum size can also be made smaller by further lowering the viscosity of the varnish. Similarly, the abovementioned area proportion of the cavities can be made smaller by further lowering the solid content concentration of the varnish (to be discussed in details later) or by further lowering the viscosity of the varnish.

### [Method for observing surface of sinter bonding layer]

The surface of the sinter bonding layer 2 is observed as follows. Then, the observation image is analyzed to obtain the maximum size among the sizes of the cavities observed (i.e., the size of the largest cavity) and the area proportion of the cavities.

The surface of the sinter bonding layer is observed using an optical microscope at a magnification of 100 times. A central portion of one surface (i.e., surface not in contact with the support layer 1) of the sinter bonding layer is selected as an observation position. As the optical microscope, for example, a digital microscope is used. More specifically, an image is captured of the sinter bonding layer placed on a piece of transparent glass and irradiated with light from both above and below. As the specific conditions such as lighting and focusing for capturing the image, employed can be, for example, the conditions described in the later section of Image Analysis in

### EXAMPLES.

### [Method for analyzing observation image]

Each image captured as above is analyzed as follows. Specifically, an area with a color saturation of 0 to 50 is first extracted from the image for clear differentiation between portions in the image of the cavities and the remaining portions. Preferably, the conditions for, for example, lighting and focusing are adjusted to allow borderlines defined with a color saturation of 50 to conform to outlines (outer peripheral edges) of the cavities. For example, the image is subjected to binarization processing under such conditions to allow the remaining portions to turn white and allow the portions of the cavities to turn colored. Next, the maximum size among the sizes of the cavities (i.e., the size of the largest cavity) extracted from each image is obtained. As the cavities have various shapes, the size of each cavity is defined by the length of a straight line connecting the two points positioned farthest from each other. Further, the area proportion of the cavities is determined within the observation image with the area of at least 9 mm². Specifically, the area proportion of the cavities that have turned black is calculated within the observation image with the area of at least 9 mm². The observation image with the area of at least 9 mm² preferably has a square shape. The area of the observation image can be at least 9 mm², and is preferably 9 mm² or more and 11 mm² or less. The area proportions are calculated for at least five observation images selected at random, and their values are arithmetically averaged to finally obtain the area proportion of the cavities. The image analysis can be carried out by, for example, software accompanied by an apparatus such as a digital microscope.

The conductive metal contained in the sinterable particles is a metal having an electrical conductivity of 100 [µS/cm] or more (10⁶ [S/m] or more) as measured according to JIS K 0130 (2008). Examples of the conductive metal include gold, silver, copper, palladium, tin, and nickel. The conductive metal can be an alloy of two or more metals selected from the group consisting of gold, silver, copper, palladium, tin, and nickel. The sinterable particles can include a metal oxide such as silver oxide, copper oxide, palladium oxide, or tin oxide.

In this embodiment, the sinterable particles preferably include at least one selected from the group consisting of silver, copper, silver oxide, and copper oxide. This configuration can achieve better bonding properties for bonding the semiconductor element to the board via the individual piece of the sinter bonding layer 2 (individual piece 2' of the sinter bonding layer), as will be described later.

The sinterable particles preferably include, as the conductive metal, at least one of silver and copper. This configuration enables the sinter bonding layer 2 to achieve better thermal conductivity and better electrical conductivity.

In terms of oxidation resistance, the sinterable particles preferably include silver as the conductive metal. When the sinterable particles include silver, sintering treatment can be carried out suitably even in an air atmosphere. Specifically, for example, the sintering treatment when bonding the semiconductor element such as the semiconductor chip B to the board can be suitably carried out in an air atmosphere. In contrast, when the sinterable particles include, for example, copper, the sintering treatment is preferably carried out in an inactive environment such as a nitrogen atmosphere to prevent the copper from being oxidized.

The sinterable particles can include a metal oxide. For example, the sinterable particles can be formed of metal particles with their surface portions transformed into a metal oxide.

For example, the sinterable particles can each have a core-shell structure having a core portion and a shell portion covering the core portion. The core portion can include, as the main component, at least one of silver and copper. The shell portion can include, as the main component, gold, silver, silver oxide, or copper oxide. For example, the sinterable particles can be formed of silver particles with their surfaces at least partially covered with silver oxide, or can be formed of copper particles with their surfaces at least partially covered with copper oxide. More specifically, the particles made of a plurality of kinds of metal can each be, for example, a particle having a core portion made of nickel, copper, silver, aluminum, or the like and a shell portion at least partially covering a surface of the core portion and made of gold, silver, copper, or the like.

In addition, examples of the sinterable particles include composite particles including a metal and a material other than the metal. Examples of the composite particles include particles each having a core part formed of, for example a resin particle, and a surface part at least partially covering a surface of the core part and made of a metal such as nickel or gold. The core part can be made of a carbon material such as carbon black or a carbon nanotube. As the composite particles, employed can be, for example, metal particles with their surfaces subjected to surface treatment by a fatty acid.

When the sinterable particles include silver, more specifically, when the sinterable particles are silver particles, the silver particles can include a silver element and other elements being inevitable impurity elements (e.g., metal elements). Alternatively, the silver particles can be subjected to surface treatment (e.g., silane coupling treatment). Examples of the surface treatment agent for the silver particles include a fatty acid-based coating agent, an amine-based coating agent, and an epoxy-based coating agent.

As the silver particles, those silver particles with their surfaces treated with a coating agent (hereinafter referred to also as coating agent treated silver particles) are preferable because use of the coating agent treated silver particles as the sinterable particles can further increase affinity between the organic binder and the sinterable particles in the sinter bonding layer 2 before sintering treatment. This configuration can more sufficiently disperse the sinterable particles in the sinter bonding layer 2 before sintering treatment. As will be described later on the production of a semiconductor device, the sintering treatment for the sinter bonding layer 2 at a certain temperature or higher at least partially eliminates the organic binder from the sinter bonding layer 2.

Only one kind of the aforementioned sinterable particles can be employed, or two or more kinds of these can be employed in combination.

The sinterable particles have, for example, a needle shape, a thread shape, a spherical shape, or a plate shape (including a scale shape). Among these shapes, a spherical shape is preferable. The sinterable particles having a spherical shape can be more favorably dispersed in a later-described varnish for obtaining the sinter bonding layer 2.

The sinterable particles are sintered to each other by the sintering treatment in which heating is carried out to a certain temperature. The sinterable particles are particles each having at least a part made of the conductive metal and fixed to each other when heated at a certain temperature. Thus, a heat transmission path is formed by the sintering treatment inside the sinter bonding layer 2. In particular, the heat transmission path is formed in a thickness direction of the sinter bonding layer 2. This enables the sinter bonding layer 2 to have a relatively high heat conductivity (heat dissipation).

The sinterable particles can be sinterable at a heating temperature of 400 °C or less. In other words, employed can be those sinterable particles with necking found on their outer surfaces when heated at a temperature of 400 °C or less.

The temperature at which the sinterable particles are sintered can be measured using a thermogravimetric and differential thermal analyzer. Specifically, the measurement is carried out using a thermogravimetric and differential thermal analyzer (for example, the differential thermal balance TG8120 manufactured by Rigaku Corporation) under the following conditions. A Tg curve and a DTA curve are obtained by the measurement. The temperature at the largest peak of the DTA curve found near a portion of the Tg curve beginning to decline is defined as the sintering temperature of the sinterable particles.

### <Measurement conditions>

- Temperature rising rate: 10 °C/min
- Measurement atmosphere: Air
- Measurement temperature range: Ordinary temperature (23 ± 2 °C) to 500 °C

The sinterable particles including, as the conductive metals, gold, silver, copper, palladium, tin, or nickel, or an alloy thereof are sinterable at a heating temperature of 400 °C or less.

The sinterable particles have an average particle size of preferably 1 nm or more, more preferably 10 nm or more, further preferably 50 nm or more. This configuration enables the sinterable particles to have better dispersibilty in the later-described varnish for obtaining the sinter bonding layer 2. Thus, the sinter bonding layer 2 with the sinterable particles sufficiently dispersed therein can be prepared from the varnish. The sinterable particles have an average particle size of preferably 10000 nm or less, more preferably 3000 nm or less, further preferably 1000 nm or less, particularly preferably 500 nm or less. This configuration enables the sinter bonding layer 2 to have a flatter and smoother surface.

The average particle size of the sinterable particles can be determined by observing a cross-sectional surface of the sinter bonding layer 2 using a scanning electron microscope (SEM). Specifically, the average particle size can be determined according to the steps below, which are to be performed for the sinter bonding layer 2 before sintering treatment (described later):
(1) A piece of the sinter bonding layer 2 having a thickness of 50 µm (0.05 mm) and extending to have a size of 10 mm × 10 mm in a plane direction perpendicular to the thickness direction is prepared as a measurement sample.
(2) The cross-sectional surface obtained by cutting the measurement sample is subjected to scrubbing treatment, followed by conductive treatment to fabricate a sample for SEM observation.
(3) An SEM observation image (at a magnification of 10,000 times or 100,000 times according to the size of each particle) is obtained at an acceleration voltage of 3 kV.
(4) The SEM observation image is subjected to image analysis to identify each particle. Those particles present in an end portion of the observation image are not observed. The circle equivalent diameter of each identified particle is calculated. The circle equivalent diameter is a diameter of a true circle calculated from the area of each particle assuming that the particle has a true circular shape.

The sinter bonding layer 2 includes preferably 60 mass % or more, more preferably 65 mass % or more, further preferably 70 mass % or more, most preferably 80 mass % or more, of the sinterable particles. The sinter bonding layer 2 includes 99 mass % or less, more preferably 98 mass % or less, further preferably 97 mass % or less, of the sinterable particles. The content percentage of the sinterable particles falling within the above range enables the sinter bonding layer 2 after the sintering treatment to exert sufficiently reliable bonding properties when the sinterable particles are sintered to each other through the sintering treatment to bond the semiconductor element such as the semiconductor chip B to the board.

The content percentage of the sinterable particles in the sinter bonding layer 2 can be calculated from the measured ash content remaining after the sinter bonding layer 2 is burnt. For example, the measurement can be performed according to the steps below using a thermogravimetric analyzer (e.g., TG209F1). The measurement using the thermogravimetric analyzer is preferably performed in a nitrogen gas flow.
(1) The measurement sample of the sinter bonding layer 2 weighing about 50 mg is heated from room temperature (23 ± 2 °C) to 650 °C.
(2) The temperature is kept at 650 °C for 30 minutes to thereby thermally decompose the organic binder in the measurement sample.
(3) The mass ratio of the remaining component (ash content) to the weighed value (about 50 mg) of the measurement sample is calculated.

In this embodiment, it is preferable that the sinter bonding layer 2 include, as the organic binder, a first organic binder and a second organic binder having a smaller molecular weight than that of the first organic binder.

The first organic binder is preferably a thermally decomposable polymer binder. The thermally decomposable polymer binder is a binder thermally decomposable by sintering treatment. The thermally decomposable polymer binder also has a function to have the sinter bonding layer 2 held in a sheet shape before sintering treatment. In terms of more sufficiently exerting such a function, the thermally decomposable binder is preferably solid at ordinary temperature (23 ± 2 °C). Examples of the thermally decomposable binder include a polycarbonate resin and an acrylic resin. The sinter bonding layer 2 preferably includes, as the first organic binder, at least one of the polycarbonate resin and the acrylic resin. The sinter bonding layer 2 can include only the polycarbonate resin as the first organic binder.

Examples of the polycarbonate resin include an aliphatic polycarbonate having no aromatic structure such as a benzene ring but only an aliphatic chain between carbonate esters (-O-C-O-O-) of the main chain, and an aromatic polycarbonate including an aromatic structure between carbonate esters (-O-C-O-O-) of the main chain. Examples of the aliphatic polycarbonate include polyethylene carbonate and polypropylene carbonate. Examples of the aromatic polycarbonate include a polycarbonate with its main chain having a bisphenol A structure.

Examples of the acrylic resin include a (meth)acrylate alkyl ester polymer with its linear or branched alkyl portion having 4 to 18 carbon atoms. It should be noted that the term "(meth)acryl" includes both "acryl" and "methacryl".

Examples of the alkyl group (alkyl portion) of the (meth)acrylate alkylester include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin can include, in its molecules, a polymerization unit derived from a different monomer other than the above (meth)acrylate ester. Examples of the different monomer include a carboxy group-containing monomer, an acid anhydride monomer, a hydroxy group-containing monomer, a sulfonic acid group-containing monomer, and a phosphoric acid group-containing monomer.

Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include (meth)acrylate 2-hydroxyethyl, (meth)acrylate 2-hydroxypropyl, (meth)acrylate 4-hydroxybutyl, (meth)acrylate 6-hydroxyhexyl, (meth)acrylate 8-hydroxyoctyl, (meth)acrylate 10-hydroxydecyl, (meth)acrylate 12-hydroxylauryl, and (meth)acrylate 4-(hydroxymethyl)cyclohexylmethyl. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxynaphthalene sulfonic acid. Examples of the phosphoric acid group-containing monomer include 2-hydroxyethyl acryloyl phosphate.

The second organic binder that can be included in the sinter bonding layer 2 is preferably a highly volatile binder. The highly volatile binder is a binder component that completes its weight reduction (i.e., that is entirely desorbed to a weight of 0%) at a lower temperature than that for the thermally decomposable polymer binder when measured by thermogravimetric analysis (TGA).

In this embodiment, the highly volatile binder is preferably in a liquid state having a viscosity of 1 × 10⁵ Pa· s or less at 23 °C. Such a viscosity is measured using a dynamic viscoelasticity measuring device (device name "HAAKE MARS III" manufactured by Thermo Fisher Scientific K.K.). Specifically, the viscosity is measured using parallel plates as a jig each having a diameter of 20 mm and disposed to have a gap therebetween of 100 µm, at a shear rate of 1 S⁻¹ in shearing by rotation.

Examples of the highly volatile binder include terpene alcohols, alcohols other than the terpene alcohols, alkylene glycol alkyl ethers, and ethers other than the alkylene glycol alkyl ethers.

Examples of the terpene alcohols include isobornyl cyclohexanol, cytronellol, geraniol, nerol, carveol, and α-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl methyl ether, dipropylene glycol propyl ether, dipropylene glycol butyl ether, and tripropylene glycol dimethyl ether. Examples of the ethers other than the alkylene glycol alkyl ethers include ethylene glycol ethyl ether acetate, ethylene glycol butyl ethyl acetate, diethylene glycol ethyl ether acetate, diethylene glycol butyl ethyl acetate, and dipropylene glycol methyl ether acetate.

These highly volatile binders can be individually used, or two or more of them can be used in combination.

As the highly volatile binder, the terpene alcohols are preferable, and isobornyl cyclohexanol among the terpene alcohols is more preferable, in terms of its stability at ordinary temperature.

Isobornyl cyclohexanol is referred to also as 4-[1,7,7-trimethylbicyclo[2.2.1]heptane-2-yl]cyclohexanol. Isobornyl cyclohexanol has a boiling point falling within a range of 308 °C or more and 318 °C or less. Isobornyl cyclohexanol has a vapor pressure at 25 °C of 0.00003 mmHg. Isobornyl cyclohexanol has characteristic physical properties as follows. Specifically, isobornyl cyclohexanol has properties that, when heated from ordinary temperature (23 ± 2 °C) to 600 °C in a 200 mL/min nitrogen gas flow at a temperature rising rate of 10 °C/min, isobornyl cyclohexanol begins significantly reducing its mass at 100 °C or more, and is volatilized and eliminated (i.e., no further mass reduction can be found) at 245 °C. Further, isobornyl cyclohexanol has properties of having a viscosity as extremely high as 1000000 mPa·s at 25 °C but having a viscosity as relatively low as 1000 mPa·s at 60 °C. The mass reduction is a value obtained when the mass reduction ratio at a temperature at which the measurement begins (i.e., ordinary temperature) is 0%. As described above, isobornyl cyclohexanol having this extremely high viscosity at 25 °C enables the sinter bonding layer 2 to easily maintain its sheet shape at ordinary temperature. In contrast, isobornyl cyclohexanol at 60 °C has the relatively low viscosity as above and has tackiness. That is, the sinter bonding layer 2 including isobornyl cyclohexanol can sufficiently maintain its sheet shape at ordinary temperature and have tackiness at 60 °C or higher. A semiconductor element is temporarily fixed to an adherend such as a board via the sinter bonding layer at a temperature of generally 60 to 80 °C. At such a temperature, isobornyl cyclohexanol has tackiness for the reason above. Thus, the sinter bonding layer 2 including isobornyl cyclohexanol as the second organic binder has better temporary fixing properties to an adherend such as a board. In other words, it can be further suppressed after the semiconductor element is temporarily fixed to the adherend that the attached semiconductor element is displaced or that the sinter bonding layer 2 is lifted from the adherend.

The sinter bonding layer 2 can include 1 mass % or more, 2 mass % or more, 3 mass % or more of the organic binder. The sinter bonding layer 2 includes preferably 3 mass % or more, more preferably 5 mass % or more of the organic binder. The sinter bonding layer 2 can include 40 mass % or less, 35 mass % or less, 30 mass % or less of the organic binder. The sinter bonding layer 2 includes preferably 20 mass % or less, more preferably 10 mass % or less of the organic binder.

When the sinter bonding layer 2 includes the first organic binder and the second organic binder as the organic binder, the proportion (in %) of the first organic binder to the total of the first organic binder and the second organic binder is preferably 5 mass % or more, more preferably 10 mass % or more, further preferably 20 mass % or more. In the sinter bonding layer 2, the content of the second organic binder can be larger than the content of the first organic binder. The proportion (in %) of the first organic binder to the total of the first organic binder and the second organic binder is preferably 60 mass % or less, more preferably 50 mass % or less, further preferably 40 mass % or less.

The sinter bonding layer 2 includes preferably 0.01 mass % or more, more preferably 0.05 mass % or more, further preferably 0.10 mass % or more, particularly preferably 0.20 mass % or more, of the first organic binder. The sinter bonding layer 2 includes preferably 20.0 mass % or less, more preferably 10.0 mass % or less, further preferably 7.5 mass % or less, particularly preferably 5.0 mass % or less, of the first organic binder.

The sinter bonding layer 2 includes preferably 0.5 mass % or more, more preferably 1.0 mass % or more, further preferably 1.5 mass % or more, particularly preferably 2.0 mass % or more, of the second organic binder. The sinter bonding layer 2 includes preferably 20.0 mass % or less, more preferably 15.0 mass % or less, further preferably 10.0 mass % or less, of the second organic binder.

The sinter bonding layer 2 can have a single-layered structure as shown in Fig. 1. Alternatively, the sinter bonding layer 2 can have a multilayered structure formed of a plurality of layers laminated on each other. When the sinter bonding layer 2 has a multilayered structure, the maximum size among the sizes of the cavities in at least one layer forming the sinter bonding layer 2 can be 100 µm or less as described above,

The sinter bonding layer 2 has a complex viscosity at 25 °C of, for example, 3.0 × 10⁵ [Pa·s] or more and 3.0 × 10¹¹ [Pa's] or less. The complex viscosity at 25 °C of the sinter bonding layer 2 is preferably 3.0 × 10⁶ [Pa-s] or more, more preferably 3.0 × 10⁷ [Pa-s] or more, further preferably 7.0 × 10⁷ [Pa·s] or more. The complex viscosity at 25 °C of the sinter bonding layer 2 is preferably 3.0 × 10¹⁰ [Pa·s] or less, more preferably 3.0 × 10⁹ [Pa-s] or less, further preferably 7.0 × 10⁸ [Pa-s] or less. The sinter bonding layer 2 has a complex viscosity at 93 °C of, for example, 3.0 × 10⁴ [Pa·s] or more and 3.0 × 10¹⁰ [Pa·s] or less. The complex viscosity at 93 °C of the sinter bonding layer 2 is preferably 3.0 × 10⁵ [Pa-s] or more, more preferably 3.0 × 10⁶ [Pa-s] or more, further preferably 7.0 × 10⁶ [Pa·s] or more. The complex viscosity at 93 °C of the sinter bonding layer 2 is preferably 3.0 × 10⁹ [Pa-s] or less, more preferably 3.0 × 10⁸ [Pa-s] or less, further preferably 7.0 × 10⁷ [Pa-s] or less. Since the sinter bonding layer 2 has the complex viscosity falling within the above range, the cavities that can be present in the sinter bonding layer 2 before being subjected to sintering treatment (to be described later) tend to be made smaller during the sintering treatment. Thus, even when the sinter bonding layer 2 after the sintering treatment is exposed to repetitive temperature increases and decreases during use, it can be further suppressed that the sinter bonding layer 2 and the adherend are partially separated from each other at an interface therebetween and that cracks are made inside the sinter bonding layer 2. The bonding between the sinter bonding layer 2 and the adherend can accordingly be more sufficiently maintained even when the sinter bonding layer 2 is exposed to repetitive temperature increases and decreases during use.

The complex viscosity of the sinter bonding layer 2 is measured under the following measurement conditions:
Test piece cut out of the sinter bonding layer: 30 mm long and 5 mm wide
Measuring device: Dynamic viscoelasticity measuring device
(e.g., product name "RSA-G2" manufactured by TA Instruments)
Measurement mode: Tensile mode
Initial distance between chucks: 20 mm
Tensile speed: 1 mm/sec
Measurement temperature: Rises from 10 °C to 100 °C (temperature rising rate: 5 °C/min)
Read at least the value [Pa-s] of the complex viscosity (complex coefficient of viscosity η*) at 25 °C

Two PET liners (each having a thickness of 50 µm) subjected to silicone release treatment are used as buffers for the chucks in order to prevent the test piece from being broken when the test piece is fixed to a chuck jig. The test piece is made to be caught between these PET liners.

The complex viscosity can be made smaller when, for example, a larger amount of the organic binder is included in the sinter bonding layer 2. In contrast, the complex viscosity can be made larger when a smaller amount of the organic binder is included in the sinter bonding layer 2.

In this embodiment, the sinter bonding layer 2 has a thickness of preferably 5 µm or more, more preferably 10 µm or more. The thickness of the sinter bonding layer 2 can be 300 µm or less, can be 200 µm or less, can be 100 µm or less. In general, the thinner the sinter bonding layer 2 is, the more likely the cracks are made inside the sinter bonding layer 2 when the sinter bonding layer 2 during use is exposed to repetitive temperature increases and decreases. In this embodiment, in contrast, the maximum size among the sizes of the cavities in the sinter bonding layer 2 is 100 µm or less (i.e., the largest cavity has a size of 100 µm or less) as aforementioned. Thus, even when the sinter bonding layer 2 having a relatively small thickness is exposed to repetitive temperature increases and decreases during use, cracks are suppressed from being made inside the sinter bonding layer 2. Further, the sinter bonding layer 2 and the adherend can be suppressed from being partially separated from each other at the interface therebetween due to, for example, the cavities above. Accordingly, the bonding between the sinter bonding layer 2 and the adherend can be sufficiently maintained.

The thickness of the sinter bonding layer 2 is calculated by measuring the thickness thereof at any five positions selected at random using a dial gauge (model R-205 manufactured by PEACOCK), followed by arithmetically averaging these thickness values.

### [Support layer of sinter bonding sheet]

In this embodiment, the support layer 1 of the sinter bonding sheet 10 functions as a support body of the sinter bonding sheet 10. The support layer 1 is formed of, for example, a plastic film.

Examples of the material of the plastic film include a polyolefin resin, a polyester resin, a polyurethane resin, a polycarbonate resin, a polyether ether ketone resin, a polyimide resin, a polyether imide resin, a polyamide resin, a wholly aromatic polyamide resin, a polyvinyl chloride resin, a polyvinylidene chloride resin, a polyphenyl sulfide resin, an aramid resin, a fluororesin, a cellulose-based resin, and a silicone resin. The support layer 1 can be formed of a single material, or can be formed of two or more materials.

Examples of the polyolefin resin include a low-density polyethylene resin, a linear low-density polyethylene resin, a middle-density polyethylene resin, a high-density polyethylene resin, an ultralow-density polyethylene resin, a random copolymer polypropylene resin, a block copolymer polypropylene resin, a homopolypropylene resin, a polybutene resin, a polymethylpentene resin, an ethylene-vinyl acetate copolymer resin, an ionomer resin, an ethylene-butene copolymer resin, and an ethylene-hexene copolymer resin. Examples of the polyester resin include a polyethylene terephthalate resin, a polyethylene naphthalate resin, and a polybutylene terephthalate resin.

The support layer 1 can have a single-layered structure, or can have a multilayered structure. The single-layered structure means a structure formed of a single material. For example, the support layer 1 in which two or more layers each made of a single material are laminated on each other has a single-layered structure. In contrast, the support layer 1 in which two or more layers respectively made of different materials are laminated on each other has a multilayered structure.

When the support layer 1 is a plastic film, the support layer 1 can be a non-oriented film, or can be an oriented film. The oriented film can be a uniaxially-oriented film, or can be a biaxially-oriented film. The support layer 1 can be a release liner whose surface in contact with the sinter bonding layer 2 is subjected to release treatment. One surface of the support layer 1 in contact with the sinter bonding layer 2 is, for example, coated with a releasing agent. In this case, the individual piece of the sinter bonding layer 2 (i.e., individual piece 2' of the sinter bonding layer) can be easily separated from the one surface of the support layer 1 (i.e., release liner) in producing the semiconductor device.

The thickness of the support layer 1 is preferably 10 µm or more, more preferably 20 µm or more, further preferably 30 µm or more. The thickness of the support layer 1 is preferably 5000 µm or less, more preferably 4000 µm or less, further preferably 3000 µm or less. The thickness of the support layer 1 is measured in the same manner as in the thickness of the sinter bonding layer 1 as aforementioned.

Next, a description will be given on a method for producing the aforementioned sinter bonding sheet.

A method for producing the sinter bonding sheet includes: a step of preparing a varnish including: sinterable particles containing a conductive metal; an organic binder; and an organic solvent; and a step of fabricating a sinter bonding layer by volatilizing the organic solvent from the varnish.

In the step of preparing the varnish, for example, the sinterable particles, the organic binder, and the organic solvent are mixed together to disperse the sinterable particles in the organic solvent and dissolve the organic binder in the organic solvent, thereby preparing the varnish.

As the organic solvent, for example, alcohols such as ethanol or ketones such as methyl ethyl ketone (MEK) can be used.

The mixing temperature for preparing the varnish is not particularly limited, and is, for example, 5 °C or more and 70 °C or less. No method for mixing the varnish is particularly limited, and any mixing method using a general stirrer can be employed.

The solid content concentration of the varnish is preferably 60 mass % or less, more preferably 58 mass % or less, further preferably 55 mass % or less. The solid content refers to the component obtained by removing the organic solvent from the varnish, and is, for example, the total of the sinterable particles and the organic binder. The varnish having a lower solid content concentration tends to make smaller the cavities that may be formed when volatilizing the organic solvent from the varnish (to be discussed later) at the time of producing the sinter bonding layer 2. The cavities of the sinter bonding layer 2 after sintering treatment are accordingly made smaller. Thus, the sinter bonding layer 2 and the adherend are further suppressed from being partially separated from each other at the interface therebetween due to the cavities even when the sinter bonding layer 2 during use is exposed to repetitive temperature increases and decreases. Also, cracks resulting from the cavities are further suppressed from being made inside the sinter bonding layer 2. The bonding between the sinter bonding layer 2 and the adherend can accordingly be more sufficiently maintained. The solid content concentration of the varnish can be 30 mass % or more, 40 mass % or more, 50 mass % or more, 52 mass % or more.

The varnish has a viscosity at 23 °C of preferably 1.0 [Pa s] or more and 7.0 [Pa·s] or less, more preferably 2.0 [Pa·s] or more and 5.0 [Pa·s] or less. Such a viscosity is measured using an E-type viscometer (e.g., device name "RE-85" manufactured by Toki Sangyo Co., Ltd). Specifically, a "1°34' × R24" cone rotor as a jig is used with a measurement sample in an amount of 1.1 mL at a rotation speed of 1.0 rpm for the measurement of the viscosity. The varnish having a lower viscosity tends to make smaller the cavities that may be formed when volatilizing the organic solvent from the varnish (to be discussed later) at the time of producing the sinter bonding layer 2. The cavities of the sinter bonding layer 2 after sintering treatment are accordingly made smaller. Thus, the sinter bonding layer 2 and the adherend are further suppressed from being partially separated from each other at the interface therebetween due to the cavities even when the sinter bonding layer 2 during use is exposed to repetitive temperature increases and decreases. Also, cracks resulting from the cavities are further suppressed from being made inside the sinter bonding layer 2. The bonding between the sinter bonding layer 2 and the adherend can accordingly be more sufficiently maintained.

In the step of fabricating the sinter bonding layer, for example, the varnish is applied with a certain thickness onto the support layer 1 to form a coating film. Subsequently, the coating film is heated to volatilize the organic solvent.

The sinter bonding sheet 10 produced as above can be used as, for example, an auxiliary member for producing the semiconductor device.

### [Method for using sinter bonding sheet (method for producing semiconductor device)]

Next, a description will be given on one example of a method for producing a semiconductor device using the sinter bonding sheet 10 according to this embodiment, with reference to the drawings.

The method for producing the semiconductor device according to this embodiment is carried out using, for example: a plurality of the semiconductor chips B; a board having a plurality of mounting areas on which the plurality of semiconductor chips B are to be respectively mounted; the sinter bonding sheet 10; and a pressing member used for temporarily fixing each of the plurality of semiconductor chips B to each corresponding one of the plurality of mounting areas.

A description hereinafter will be given by taking, for example, the case where the semiconductor chips B are mounted on the board such as a DBC (Directed Bonded Copper) board or an AMB (Active Metal Brazing) board using a collet A as the pressing member. Each of these boards includes a ceramic insulating layer D, and a copper die pad E and a copper thin layer F on the respective sides of the ceramic insulating layer D. The copper die pad E corresponds to the mounting areas of the semiconductor chips B.

First, a semiconductor wafer is cut on a dicing tape C to obtain the plurality of semiconductor chips B out of the semiconductor wafer (see Fig. 2A). In other words, the semiconductor wafer is divided into a plurality of individual pieces to obtain the semiconductor chips B. Used as the dicing tape C can be any commercially available product.

Each of the obtained semiconductor chips B has, for example, a rectangular sheet shape. The semiconductor chip B has a thickness of, for example, 10 µm or more and 500 µm or less. The semiconductor chip B has a thickness of preferably 20 µm or more and 400 µm or less. The semiconductor chip B has an area of, for example, 0.01 mm² or more and 1000 mm² or less as viewed from one side of the thickness direction. Such an area is preferably 0.04 mm² or more and 500 mm² or less.

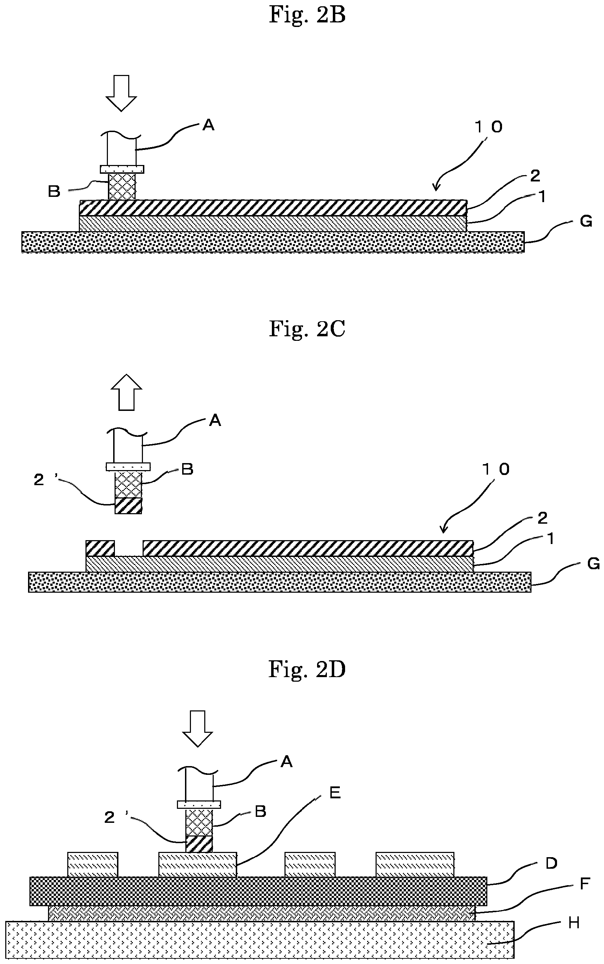

Next, as shown in Fig. 2B, the sinter bonding sheet 10 is placed on a first stage G to have the sinter bonding layer 2 located on an upper side of the support layer 1. Then, one semiconductor chip B is pressed at the sinter bonding layer 2 using the collet A to have the semiconductor chip B attached to a part of the sinter bonding layer 2. The pressure during the pressing is preferably 0.01 MPa or more and 10 MPa or less, more preferably 0.1 MPa or more and 5 MPa or less. The temperature of the collet A or the first stage G during the pressing is preferably 40 °C or more and 150 °C or less, more preferably 50 °C or more and 130 °C or less. The surface of the collect A in abutting contact with the semiconductor chip B has a shape and a size substantially corresponding to the shape and the size of the one semiconductor chip B as described above.

Next, the collect A is lifted up as shown in Fig. 2C. In so doing, the part of the sinter bonding layer 2 attached to the semiconductor chip B is lifted up together with the semiconductor chip B. In other words, the semiconductor chip B with the individual piece 2' of the sinter bonding layer adhering thereto is lifted up with the collect A. Thus, the semiconductor chip B with the individual piece of the sinter bonding layer 2 (also referred to as individual piece 2' of the sinter bonding layer) attached thereto is obtained. The pressure for pressing the semiconductor chip B at the sinter bonding layer 2 falling within the aforementioned range, or the temperature of the collet A or the first stage G falling within the aforementioned range enables the semiconductor chip B with the individual piece 2' of the sinter bonding layer attached thereto to be favorably obtained.

Next, the board (the ceramic insulating layer D, the copper die pad E, and the copper thin layer F) is placed on a second stage H (see Fig. 2D). Then, as shown in Fig. 2D, the collet A held at any temperature within the range of 25 °C or more and 150 °C or less is caused to descend in a vertical direction to bring the individual piece 2' of the sinter bonding layer attached to the semiconductor chip B into abutting contact with the copper die pad E. Subsequently, the semiconductor chip B is pressed downward at the copper die pad E using the collet A. The semiconductor chip B is thereby temporarily fixed to the copper die pad E via the individual piece 2' of the sinter bonding layer (see Fig. 2D). The pressure at which the semiconductor chip B is pressed at the copper die pad E is preferably 0.01 MPa or more and 50 MPa or less, more preferably 0.1 MPa or more and 30 MPa or less.

The board as an adherend of the individual piece 2' of the sinter bonding layer can be a lead frame. A general lead frame can be used as the lead frame. For example, a lead frame formed of a Cu frame plated with Ag, or a lead frame formed of a Cu frame plated with Ni, Pd, and Au in this order (palladium pre-plated lead frame; Pd-PPF) can be employed.

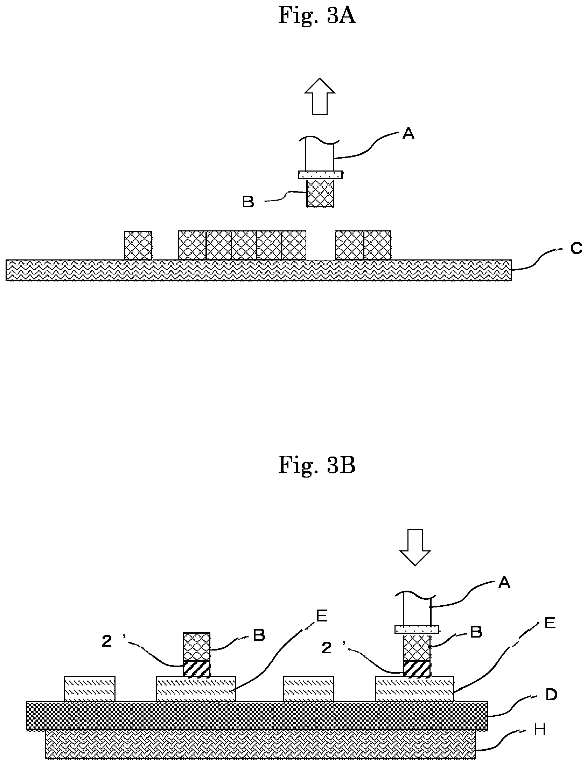

The operations above are carried out to temporarily fix the one semiconductor chip B to the copper die pad E, followed by repeatedly carrying out the same operations. Specifically, as shown in Fig. 3A, another semiconductor chip B out of the plurality of semiconductor chips B is separated and lifted up from the dicing tape C using the collet A. Next, similarly to Fig. 2B, the other semiconductor chip B is pressed at the sinter bonding layer 2 of the sinter bonding sheet 10 using the collet A. Further, similarly to Fig. 2C, the collet A is drawn up to separate and lift up the other semiconductor chip B with the individual piece 2' of the sinter bonding layer attached thereto from the support layer 1. Subsequently, while the collet A is held at a temperature similar to that above, the other semiconductor chip B with the individual piece 2' of the sinter bonding layer attached thereto is brought into abutting contact with another mounting area in the copper die pad E. Further, the other semiconductor chip B is pressed downward at the copper die pad E using the collet A, as shown in Fig. 3B. The other semiconductor chip B is thereby temporarily fixed to the other mounting area in the copper die pad E via the individual piece 2' of the sinter bonding layer (see Fig. 3B). These operations are sequentially carried out in a repeated manner until all those semiconductor chips B to be temporarily fixed to the copper die pad E are disposed on the copper die pad E.

When each of the semiconductor chips B is temporarily fixed, the collet A can be heated to a temperature at which the sinterable particles included in the individual piece 2' of the sinter bonding layer can be sintered. The sinterable particles included in the individual piece 2' of the sinter bonding layer can be thereby subjected to primary sintering treatment. In other words, the sintering treatment can be partially carried out for the individual piece 2' of the sinter bonding layer immediately after the temporary fixing as above.

When the sinterable particles included in the individual piece 2' of the sinter bonding layer can be sintered at a heating temperature of 400 °C or less, the collet A is preferably heated to a temperature of 200 °C or more. The collet A heated to 200 °C or more enables the sinterable particles to be more sufficiently sintered to each other. Accordingly, the semiconductor chip B can be more firmly bonded to the copper die pad E via the individual piece 2' of the sinter bonding layer. In other words, the semiconductor chip B is imparted an increased bonding reliability to the board.

When the above primary sintering treatment is carried out, it is preferable that the collet A be heated rapidly (i.e., within about 5 seconds). The collet A is preferably heated at a temperature rising rate of 30 °C/sec or more, more preferably heated at a temperature rising rate of 45 °C/sec or more.

The primary sintering treatment can be carried out not only by heating the collet A but also by heating the second stage H as well at the temperature as above. This enables the individual piece 2' of the sinter bonding layer to be heated from both sides in the thickness direction, and thus enables the sinterable particles to be sufficiently sintered to each other. Accordingly, the semiconductor chip B can be more sufficiently bonded to the copper die pad E via the individual piece 2' of the sinter bonding layer. In other words, the semiconductor chip B is imparted a further increased bonding reliability to the board.

The heated second stage H preferably has such a temperature or less as to suppress the copper die pad E or the copper thin layer F from being oxidized. The heating temperature of the second stage H is preferably 150 °C or less.

When the primary sintering treatment is carried out as above, for example, the temperature of the collet A can be decreased to a temperature at which the sinterable particles are hardly sintered to each other (e.g., 50 °C) by lifting up the collet A after the primary sintering treatment to make a clearance between the semiconductor chip B and the collet A. When each of all individual pieces 2' of the sinter bonding layer is subjected to the primary sintering treatment, bonding wires can be bonded to required positions after all the semiconductor chips B are bonded.

In the method for producing the semiconductor device according to this embodiment, a heating step of heating the individual piece 2' of the sinter bonding layer to a temperature at which the sinterable particles are sinterable to each other can be carried out after the plurality of semiconductor chips B are temporarily fixed to the board. In the heating step, heating can be carried out while compression force is applied in the thickness direction to at least any one of the plurality of individual pieces 2' of the sinter bonding layer. When the primary sintering treatment as described above is carried out, the heating step corresponds to a secondary sintering treatment. In other words, the sintering treatment can be carried out by both the primary sintering treatment and the secondary sintering treatment (i.e., the above heating step) as described above.

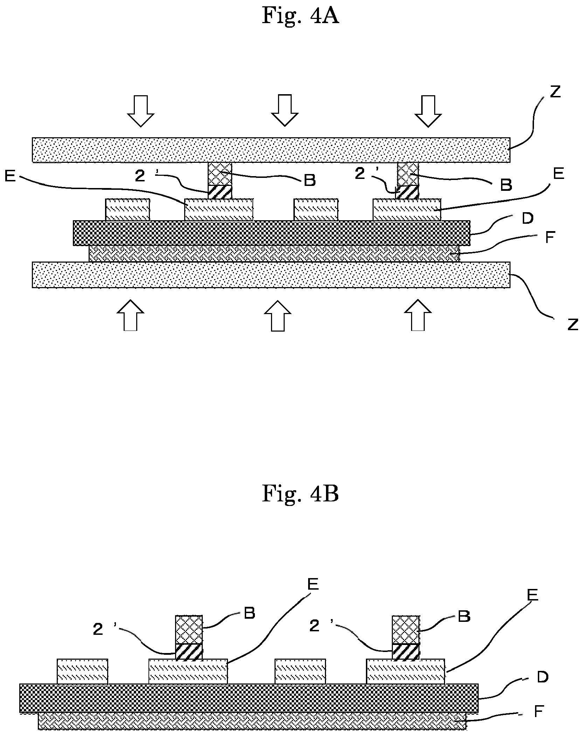

More specifically, in the method for producing the semiconductor device according to this embodiment, the sintering treatment can be carried out as follow. In the heating step of the sintering treatment, for example, heating is carried out while at least any one of the plurality of the individual pieces 2' of the sinter bonding layer is pressed in its thickness direction. Specifically, after the semiconductor chips B are temporarily fixed, heating can be carried out using a heating and pressurizing device configured to be capable of heating while compression force is applied in the thickness direction to the individual pieces 2' of the sinter bonding layer, as shown in Fig. 4A. The heating and pressurizing device is composed of, for example, two flat plates Z. The two flat plates Z are placed to allow the second stage H, the board (the ceramic insulating layer D, the copper die pad E, and the copper thin layer F), and the plurality of semiconductor chips B temporarily fixed to the copper die pad E via the respective individual pieces 2' of the sinter bonding layer to be sandwiched therebetween. Then, a distance between the two heated flat plates is made small to pressurize (press) the plurality of members above, thereby heating the individual pieces 2' of the sinter bonding layer while pressing these pieces. The heating step thus carried out enables the plurality of individual pieces 2' of the sinter bonding layer to be heated while being pressed, thereby being capable of firmly bonding the semiconductor chips B to the board (copper die pad E) via the respective individual pieces 2' of the sinter bonding layer. Accordingly, the semiconductor chips B can be imparted an increased bonding reliability to the board. Following such a heating step, bonding wires can be bonded to required positions. A jig for arranging a plurality of the boards, for example, can be disposed between the copper die pad E and a lower one of the flat plates Z shown in Fig. 4A.

In the heating step, in contrast, after all those semiconductor chips B to be bonded are temporarily fixed, the second stage H can be heated without applying compression force in the thickness direction to the respective individual pieces 2' of the sinter bonding layer, as shown in Fig. 4B. In so doing, the second stage H is heated at a temperature at which the sinterable particles included in the individual pieces 2' of the sinter bonding layer are made sinterable (for example, any temperature within a range of 200 °C or more and 400 °C or less). Such a heating step still enables the semiconductor chips B to be firmly bonded to the board (copper die pad E) via the respective individual pieces 2' of the sinter bonding layer. Accordingly, the semiconductor chips B can be imparted an increased bonding reliability to the board. The heating step as above eliminates the necessity of the heating and pressurizing device for applying compression force to the individual pieces 2' of the sinter bonding layer, and can thus only require further simplified production equipment.

In the method for producing the semiconductor device according to this embodiment, further steps can be carried out. For example, a wire bonding step of electrically connecting a part of each of the semiconductor chips B and a part of the board to each other can be carried out. Further, a sealing step of sealing, for example, the semiconductor chip B and the individual piece 2' of the sinter bonding layer using a thermosetting resin such as an epoxy resin can be carried out. In the sealing step, heating treatment is performed at a temperature of, for example, 150 °C or more and 200 °C or less to allow the curing reaction of the thermosetting resin to proceed.

In the method for producing the semiconductor device according to this embodiment, the individual piece 2' of the sinter bonding layer is subjected to sintering treatment while being applied with compression force in the thickness direction to bond the individual piece 2' of the sinter bonding layer to the board as described above. As aforementioned, a maximum size among sizes of cavities observed in the observation image of the surface of the sinter bonding layer 2 at a magnification of 100 times is 100 µm or less. The area proportion of the cavities within the observation image with the area of at least 9 mm² is preferably 5% or less. The sinter bonding layer 2 configured as above has cavities with a small maximum size, or in some cases has few cavities therein. Accordingly, the sinter bonding layer 2 after sintering treatment has cavities with a small maximum size, or in some cases can have the cavities eliminated. Thus, the sinter bonding layer and the adherend are suppressed from being partially separated from each other at the interface therebetween at least due to the cavities even when the sinter bonding layer 2 during use is exposed to repetitive temperature increases and decreases. Also, cracks at least resulting from the cavities are suppressed from being made inside the sinter bonding layer 2. The bonding between the sinter bonding layer 2 and the adherend can accordingly be sufficiently maintained even when the sinter bonding layer 2 during use is exposed to repetitive temperature increases and decreases.

The sinter bonding sheet of this embodiment has been described as above, but the present invention is not limited to the above-described sinter bonding sheet. That is, various forms used in, for example, general sinter bonding sheets can be employed without impairing the effect of the present invention.

The matters disclosed herein include the following.
(1) A sinter bonding sheet including a sinter bonding layer that includes: sinterable particles containing a conductive metal; and an organic binder, in which a maximum size among sizes of cavities observed in an observation image of a surface of the sinter bonding layer at a magnification of 100 times is 100 µm or less. The sinter bonding sheet configured as above can sufficiently maintain bonding to an adherend even if used in an environment in which temperature increases and decreases repetitively.
(2) The sinter bonding sheet according to (1) above, in which an area proportion of the cavities within the observation image with an area of at least 9 mm² is 5.0% or less.
(3) The sinter bonding sheet according to (1) or (2) above, in which the sinter bonding layer has a complex viscosity at 25 °C of 3 × 10⁵ [Pa-s] or more and 3 × 10¹¹ [Pa·s] or less.
(4) The sinter bonding sheet according to any one of (1) to (3), in which the sinter bonding layer has a complex viscosity at 93 °C of 3 × 10⁴ [Pa·s] or more and 3 × 10¹⁰ [Pa·s] or less.
(5) The sinter bonding sheet according to any one of (1) to (4) above, in which the sinterable particles have an average particle size of 1 nm or more and 10000 nm or less, preferably 50 nm or more and 500 nm or less.
(6) The sinter bonding sheet according to any one of (1) to (5) above, in which the sinter bonding layer includes, as the organic binder, a first organic binder and a second organic binder having a smaller molecular weight than that of the first organic binder.
(7) The sinter bonding sheet according to (6) above, in which the first organic binder is a thermally decomposable polymer binder.
(8) The sinter bonding sheet according to any one of (1) to (7) above, in which the sinter bonding layer includes 60 mass % or more and 99 mass % or less of the sinterable particles.
(9) The sinter bonding sheet according to any one of (1) to (8) above, in which the sinter bonding layer includes 1 mass % or more and 40 mass % or less of the organic binder.
(10) A method for producing the sinter bonding sheet according to any one of (1) to (9) above, the method including: a step of preparing a varnish including the sinterable particles, the organic binder, and an organic solvent; and a step of fabricating the sinter bonding layer by volatizing the organic solvent from the varnish.

### EXAMPLES

Next, the present invention will be described in more detail by way of experimental examples. The following examples are intended to illustrate the present invention in further detail, and are not intended to limit the scope of the present invention.

### (Materials of sinter bonding layer)

### [Sinterable particles]

- First silver particles:
   Average particle size of 60 nm, manufactured by DOWA ELECTRONICS MATERIALS CO., LTD.
- Second silver particles:
   Average particle size of 1100 nm, manufactured by Mitsui Mining & Smelting Co., Ltd.

### [Organic binders]

- First organic binder (thermally decomposable polymer binder): Polycarbonate resin: (biphenyl type phenol resin, phenol equivalent of 209 g/eq)
   Product name: "QPAC 40" manufactured by Empower Materials
- Second organic binder (highly volatile binder): Isobornyl cyclohexanol Product name "Terusolve MTPH" manufactured by NIPPON TERPENE CHEMICALS, INC.
- Organic solvent: Methyl ethyl ketone (MEK)

### (Support layer)

- Release treatment film (Product name "MRA 38" manufactured by Mitsubishi Chemical Corporation)

### (Example 1)

The first silver particles, the second silver particles, the first organic binder (polycarbonate resin), and the second organic binder (isobornyl cyclohexanol) were dissolved or suspended in methyl ethyl ketone (MEK) in the mixing proportions shown in Table 1 to prepare a varnish. Specifically, a hybrid mixer (model "HM-500" manufactured by Keyence Corporation) was used and the mixture was stirred in a stirring mode for three minutes. Next, a release treatment surface of the support layer was coated with the varnish, followed by being heated at 110 °C for three minutes to thereby form a sinter bonding layer on the support layer. An intermediate product of sinter bonding sheet was thus fabricated. Next, two intermediate products of the sinter bonding sheet were attached to each other to have their sinter bonding layers in contact with each other to produce a sinter bonding sheet having a sinter bonding layer with a thickness of 50 µm. It should be noted that the mixing amounts respectively of the first silver particles and the second silver particles in Table 1 are represented by the amounts at the time of preparation, while the mixing amount of the sinterable particles in Table 2 is represented by an ash content value.

**Table 1**

| | | Mixing proportion (mass %) |
|---|---|---|
| Sinterable particles | First silver particles | 90 |
| | Second silver particles | 10 |
| Organic binders | First organic binder | 20 |
| | Second organic binder | 80 |

**Table 2**

| Unit: Mass parts (based on total solids content of 100 mass parts) | | | |
|---|---|---|---|
| Varnish composition | Composition A | Composition B | Composition C |
| Sinterable particles | 93 | 92 | 90 |
| Organic binder | 7 | 8 | 10 |

The viscosity of the varnish having each of Composition A, Composition B, and Composition C was measured according to the aforementioned measurement conditions.

### (Examples 2 to 7)

Each sinter bonding sheet was produced in the same manner as above, except that the mixing composition was changed to the corresponding composition shown in Table 3.

### (Comparative Examples 1 and 2)

Each sinter bonding sheet was produced in the same manner as above, except that the mixing composition was changed to the corresponding composition shown in Table 3.

Table 3 shows the compositions and the physical properties of the respective sinter bonding sheets according to Examples and Comparative Examples.

**Table 3**

| | Ex. 1 | Ex. 2 | Ex. 3 | Ex. 4 | Ex. 5 | C. Ex. 1 | C. Ex. 2 | Ex. 6 | Ex. 7 |
|---|---|---|---|---|---|---|---|---|---|
| Solid content concentration of varnish [mass %] | 52.0 | 55.0 | 57.5 | 60.0 | 62.0 | 65.0 | 70.0 | 65.0 | 62.0 |
| Viscosity of varnish [Pa·s] at 23 °C | 2.49 | 3.21 | 4.61 | 5.60 | 6.80 | 10.11 | 20.48 | 8.51 | 5.40 |
| Composition | A | A | A | A | A | A | A | B | C |

| Physical properties of sinter bonding layer | | | | | | | | | |
|---|---|---|---|---|---|---|---|---|---|
| Complex viscosity of sinter bonding layer at 25 °C [Pa·s] | 3.21E+ 08 | 3.21E+ 08 | 3.21E+ 08 | 3.21E+ 08 | 3.21E+ 08 | 3.21E+ 08 | 3.21E+ 08 | 6.41E+ 07 | 1.20E+ 06 |
| Same at 93 °C | 3.62E+ 07 | 3.62E+ 07 | 3.62E+ 07 | 3.62E+ 07 | 3.62E+ 07 | 3.62E+ 07 | 3.62E+ 07 | 7.78E+ 06 | 3.05E+ 05 |
| Max. size of cavity | 41 | 32 | 31 | 93 | 135 | 268 | 1429 | 90 | 93 |
| Cavity area proportion | 0.02 | 0.18 | 0.08 | 1.83 | 2.49 | 7.00 | 23.28 | 7.00 | 1.83 |

| Evaluation | | | | | | | | | |
|---|---|---|---|---|---|---|---|---|---|
| Reliability | Good | Good | Good | Good | Good | Poor | Poor | Good | Good |

### <Physical properties of sinter bonding sheet (sinter bonding layer)>

For the sinter bonding layer of each of the sinter bonding sheets produced as above, surface observation and physical properties measurement were carried out as follows:

### [Complex viscosity of sinter bonding layer]

The complex viscosity of the sinter bonding layer was measured under the following measurement conditions:
Test piece cut out of the sinter bonding layer: 30 mm long and 5 mm wide
Measuring device: Dynamic viscoelasticity measuring device
(e.g., product name "RSA-G2" manufactured by TA Instruments)
Measurement mode: Tensile mode
Initial distance between chucks: 20 mm
Tensile speed: 1 mm/sec
Measurement temperature: Rises from 10 °C to 100 °C (temperature rising rate: 5 °C/min)
Read at least the value [Pa-s] of the complex viscosity (complex coefficient of viscosity η*) at 25 °C

### [Surface observation and image analysis of sinter bonding layer]

Apparatus for use: Digital microscope, device name "VHX-2000" manufactured by Keyence Corporation
Lens: Z20, with a magnification set to 100 times
Shutter speed: 1/60 [sec]
Gain: 0 [dB]
Lighting: Lamp ON (about 90%), stage transmission illumination ON (about 20%)
Frame rate: 15 "F/s"

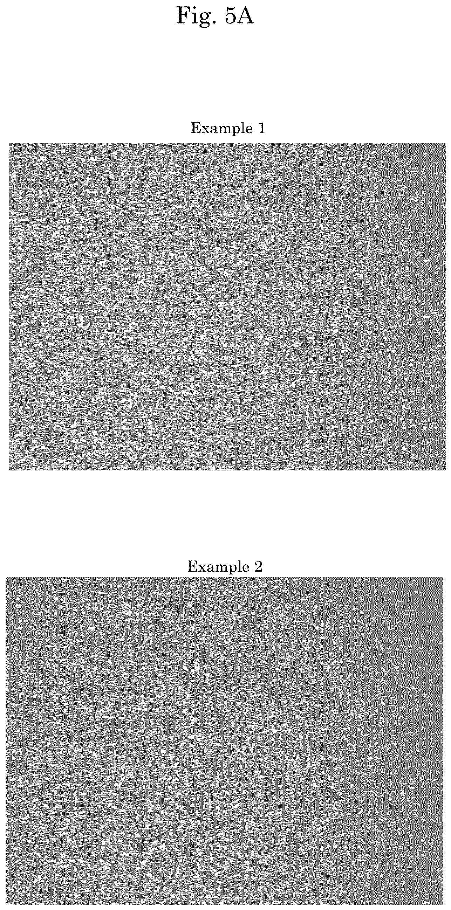

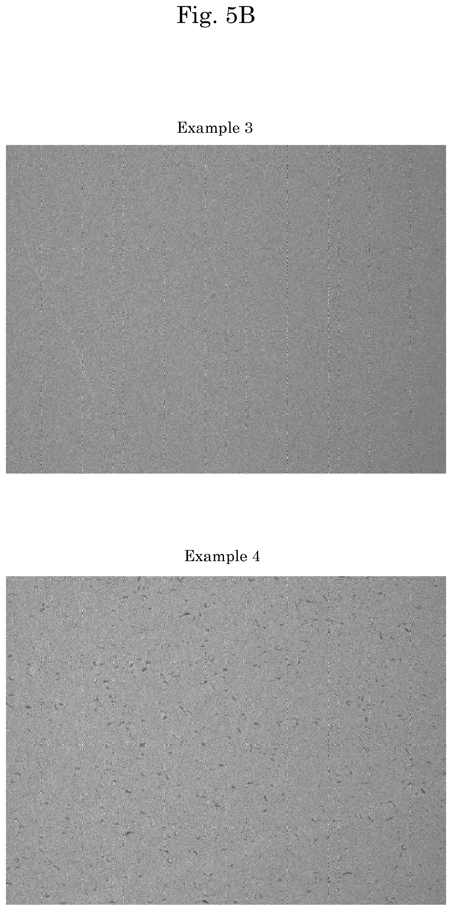

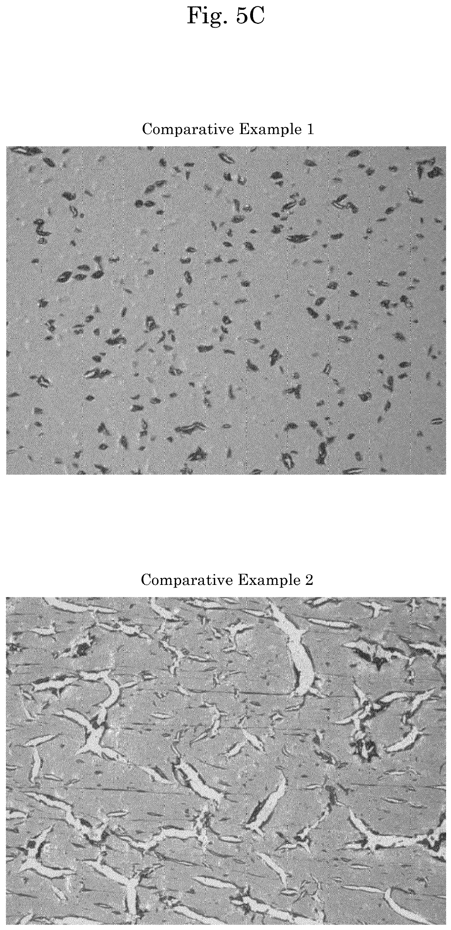

An image was captured under the conditions above. The captured image was subjected to histogram extraction for color saturation (extraction range: color saturation of 0 to 50) to obtain an observation image. Image analysis was carried out using the automatic area measurement function of the apparatus used. The image used for the image analysis had an area of about 9.7 mm². The maximum size among the sizes of the plurality of cavities, i.e., the size of the largest cavity out of the cavities, and the total area proportion of the cavities were determined from the obtained analysis results. As aforementioned, the size of each cavity is defined by the length of a straight line connecting the two points positioned farthest from each other. The observation image was binarized for the image analysis, some examples of which (i.e., Examples 1 to 4 and Comparative Examples 1 and 2) are shown in Fig. 5A to Fig. 5C.

### <Reliability evaluation of sinter bonding sheet (sinter bonding layer)>

In order to examine the likelihood of partial removal of the sinter bonding layer and the adherend from each other at the interface therebetween after temperature increases and decreases repetitively, the sinter bonding layer of each of the sinter bonding sheets produced as above was evaluated as follows. In summary, a layered product (package) including the sinter bonding layer was assembled, thereafter a temperature cycle test was performed for the layered product, and the bonding state of the sinter bonding layer was evaluated with an ultrasonic flaw detection image. Details thereof are as follows. A Cu board (20 mm × 20 mm × 3 mm thick) plated with Ag with a thickness of 5 µm, and a Si chip (5 mm × 5 mm × 0.2 mm thick) plated with Ti (0.1 µm thick) / Ag (0.75 µm thick) were prepared. Each sinter bonding layer was sandwiched between the Cu board and the Si chip to fabricate the layered product, which was then subjected to sinter bonding treatment at 300 °C and at 10 MPa for 2.5 minutes. For the layered product after the sintering treatment, the bonding states (i.e., areas of the sinter bonding layer bonded to the board and the chip respectively) at an interface between the Cu board and the sinter bonding layer and at an interface between the Si chip and the sinter bonding layer were evaluated using the ultrasonic flow detection image (initial evaluation).
Apparatus: "FineSAT 200" manufactured by Hitachi Power Solutions Co., Ltd.
Probe: PQ2-50-13 (reflection mode)
Number of measurement points: 600×600 (within 21 mm × 21 mm square)

After the initial evaluation, the layered product was placed in a temperature cycle tester for a degradation promotion test through repetitive temperature increases and decreases under the following conditions:
Temperature condition: -40 °C / 200 °C (temperatures are switched over once every 15 minutes without being allowed to stand at ordinary temperature) Number of cycles: 1000 cycles

The layered product after the degradation promotion test was evaluated with an ultrasonic flaw detection image in the same manner as above. Specifically, image analysis software ("Image 1") was used for the evaluation to compare a bonding area obtained by the initial evaluation with a bonding area obtained by the evaluation after the degradation promotion test. When the bonding area obtained by the initial evaluation was 100%, the case where the bonding area fell below 50% after the degradation promotion test (i.e., the case where the sinter bonding layer was separated in a half or more of the bonding area) was evaluated as "Poor". Other cases were evaluated as "Good".

As is understood from the evaluation results, the sinter bonding layer of the sinter bonding sheet according to each of the Examples was capable of suppressing the sinter bonding layer and the adherend from being partially separated from each other at the interface therebetween even if used in the environment in which temperature increases and decreases repetitively. That is, the sinter bonding layer had favorable bonding reliability. The sinter bonding layer of the sinter bonding sheet according to each of the Examples also had favorable thermal conductivity and electrical conductivity. The sinter bonding layer of the sinter bonding sheet according to each of the Comparative Examples, on the other hand, lacked favorable bonding reliability.

### Industrial Applicability

The sinter bonding sheet of the present invention is suitably used as, for example, an auxiliary tool for producing a semiconductor device.

### REFERENCE SIGNS LIST

10: Sinter bonding sheet
1: Support layer
2: Sinter bonding layer
A: Collet
B: Semiconductor chip
C: Dicing tape
D: Ceramic insulating layer
E: Copper die pad
F: Copper thin layer
G: First stage
H: Second stage

## Claims

1. A sinter bonding sheet comprising a sinter bonding layer that comprises:
sinterable particles containing a conductive metal; and an organic binder, wherein a maximum size among sizes of cavities observed in an observation image of a surface of the sinter bonding layer at a magnification of 100 times is 100 µm or less.

2. The sinter bonding sheet according to claim 1, wherein an area proportion of the cavities within the observation image with an area of at least 9 mm² is 5.0% or less.

3. The sinter bonding sheet according to claim 1 or 2, wherein the sinter bonding layer has a complex viscosity at 25 °C of 3.0 × 10⁶ [Pa-s] or more and 3.0 × 10¹⁰ [Pa-s] or less.

4. The sinter bonding sheet according to any one of claims 1 to 3, wherein the sinter bonding layer comprises 60 mass % or more and 99 mass % or less of the sinterable particles.

5. The sinter bonding sheet according to any one of claims 1 to 4, wherein the sinterable particles have an average particle size of 50 nm or more and 500 nm or less.
